# EUROPEAN PATENT APPLICATION

(11) **EP 4 451 173 A1**
(43) Date of publication of application: **23.10.2024**
(21) Application number: 23168160.2
(22) Date of filing: 17.04.2023
(51) Int. Cl.: G06N 3/04, G06N 3/08, G06N 5/022, G06F 30/23

(54) **METHOD FOR GENERATING A STRUCTURED MACHINE UNDERSTANDABLE INFORMATION MODEL**

(71) Applicant: ABB SCHWEIZ AG, 5400 Baden (CH)
(72) Inventor: BORRISON, Reuben, 68782 Brühl (DE); DIX, Marcel, 78476 Allensbach (DE); BERNING, Matthias, 67549 Worms (DE); ALEKSY, Markus, 67065 Ludwigshafen (DE); BAUER, Philipp, 69469 Weinheim (DE); ACKERMANN, Patric, 64405 Fischbachtal (DE)
(74) Representative: Maiwald GmbH

(57) **Abstract**

The present invention relates to a method for generating a structured machine understandable information model (10) for a building with automation control system. The method comprises the step of input (B) of metadata, comprising an unstructured or semi-structured representation in natural language of names and/or locations of sensors, devices and/or actuators within the building together with telemetry data of the sensors, devices and/or actuators of the building, into a trained machine learning system (18). In a further step of output (C) of the structured machine understandable information model (10) for the metadata and telemetry data of the building.

## Description

### FIELD OF THE INVENTION

The present invention relates a method for generating a structured machine understandable information model for a building with automation control system. Further, the present invention relates to a method for training a machine learning system for generating such an information model.

### BACKGROUND OF THE INVENTION

Telemetry data in the buildings unlocks the potential to use AI/ML technologies. However, to use this data for AI/ML methods it needs to be mapped to a standard information model or structure. Scaling these methods across different buildings require mapping the inconsistent information model to a more consistent information model which is time consuming. Buildings consist of many actuators and sensors and mapping each of them manually could be time consuming. Creating specific templates of information model and rules for mapping of the metadata may help but still the challenge would lie to map the metadata correctly and quickly. Also, this information will always be present with the experts and would require some time for the knowledge transfer to happen in-between different experts.

Prior art US 11,307,543 B2 discloses a building system for a building comprises one or more storage devices having instructions stored, when the instructions executed by one or more processors, cause the one or more processors to generate a three-dimensional building interface.

### SUMMARY OF THE INVENTION

The problem to be solved by the present invention is to provide a method for automatically generating from metadata of a building with automation control system an information model for the building.

The problem is solved by a method for generating a structured machine understandable information model for a building with automation control system having the features of claim 1. Further, a method for training a machine learning system is proposed comprising the features of claim 11. Preferred embodiments of the invention are specified in the dependent claims.

The invention proposes a method for generating a structured machine understandable information model for a building with automation control system. According to the invention an information model has to be understood as an abstract representation of objects with their properties and relationships. The information model supplements the data model with contextual information that allows a person to interpret and use data in a consistent manner. It provides the structures that make the knowledge required by a person or a group of persons in a concrete situation explicitly visible. The structure of the representation thereby is predefined. As the information model has a predefined structure it is also understandable by a machine. The expression building has to be understood as to comprise commercial and residential buildings. The building with the automation control system thereby is a smart building which is programmed to automatically control different actuators and devices in the building based on measured sensor values to obtain specific predefined conditions in the building.

The method thereby comprise the step of input of metadata, comprising an unstructured or semi-structured representation in natural language of names and/or locations of sensors, devices and/or actuators within the building together with telemetry data of the sensors, devices and/or actuators of the building, into a trained machine learning system. Natural language is understood as the language which is spoken by a human person. In other words, the data needs not be translated to a special computer language. Thereby time and effort for conducting the method can be minimized. The data thereby needs not to be in one natural language only, but also can be presented in multi-languages.

Further, as the data can be provided in an unstructured form, these data needs not to be sorted or adapted to a special representation. Accordingly, labour-intensive and error-prone manual handling of the data can be reduced. Further, it is also possible to input semi-structured data. In other words, some parts of the data are structured whereas other parts are unstructured. By using the method, the structured data thereby can be enriched with the input of the unstructured data. As some part of the data is structured the processing time of the method can be decreased. Telemetry data can be understood as data such as measured values or status data of the sensors, devices and/or actuators which are transmitted to a central location. The input of the data may come from a user. Further, it is also possible that the input data come from a database. In a further example the machine learning system also can directly extract the data from the building.

In a next step the structured machine understandable information model for the metadata and telemetry data of the building is output. With such a method it is possible to accelerate the process of mapping the data. The time and labour consuming step of mapping the data can be avoided. Accordingly, with such a method it is possible to save money to generate such an information model.

In a preferred embodiment of the invention, the generated information model is validated by a validator, which checks if the information model fits within specific constraints. The validator is a component, which checks the plausibility of the information model. For checking this, specific constraints or boundary conditions are given to the validator. Based on this information the plausibility is checked, so that information models, which are obviously not plausible are not output. With the validator it is thus possible to output only information models which obviously fulfill the requirements. Preferably, the feedback given by the validator is used to retrain the machine learning system.

In a further preferred embodiment, the validator enhances the information model by using prebuild templates for common room configuration and asset types of the building. By using prebuild templates the representation of this parts can be standardized, so that these parts always are represented in the same way. The representation and the understanding of the information model thereby is simplified.

Advantageously, the information model is a hierarchical structured model and/or graph structured based model. An output of the model as a hierarchical structured model has the advantage that elements that are mapped to a superordinate element can be recognized directly from the model. This gives a clearer understanding of the structure in the building and which actuators or devices influence which sensors. According to the invention a graph structured based model consists of a finite set of vertices. The vertices are connected to various other vertices depending on their relationship.

Preferably, the information model is generated via a natural language processing. Natural language processing describes the ability of the machine learning system to reveal the structure and the literal sense in natural language. By applying natural language processing text can be analyzed and information can be extracted from the text. The processing of the unstructured data comprising text thereby is improved.

In a further advantageous development, the information model is generated by a graph-based neural network model. A graph-based neural network model is a class of artificial neural networks for processing data that can be represented as graphs. The information model thereby is a kind of graph. By using a graph-based neural network model the generation and representation of an information model can be improved.

In a preferred example, the information model is generated via a natural language understanding and/or natural language generation. Natural language understanding describes the ability of the machine learning system extracting the context and intent in a natural language text. Thereto, natural language generation describes the ability of the machine learning system to generate text in natural language. With these abilities the machine learning system more easily is able sorting the unstructured data. The machine learning system further is able generating new expressions or text for the information model. The processing of the data and the generation of the information model is improved.

In a preferred embodiment, the metadata and the telemetry data are preprocessed before inputting the data in the machine learning system, to remove data unnecessary for the generation of the information model. By preprocessing the data, the amount of data can be reduced, so that the time for generating the information model is reduced.

Further, it is prevented that the unnecessary data results to incorrect or faulty information models. The reliability of the method thereby can be improved.

A preferred embodiment specifies that the information model is output as a graphical information. The graphical representation of the information model has the advantage that it is easy and directly understandable by a user. From the graphical representation the user directly can derive the structure of the sensors, actuators and devices in the building together with the specific values of this devices.

Preferably, the information model is adapted based on a feedback of a user. In other words, after the information model is outputted, the user provides further information or corrects different issues in the information model. Based on this further information or correction the method adapts the information model accordingly. On the basis of the input of the user, the information model can be improved.

The invention further proposes a method for training a machine learning system for generating a structured machine understandable information model for a building with automation control system. The method comprises the step of providing training data, comprising metadata provided as an unstructured representation in natural language of names and/or locations of sensors, devices and/or actuators within the building, together with telemetry data of the sensors, devices and/or actuators of the building, and an information model associated with this data. The information model thereby is the model, which results from the metadata. The training data preferably are extracted from existing information models for buildings and the respective metadata and telemetry. Thereby, time for preparing the training data set can essentially be reduced, so that a training data set can be economically provided.

In a next step of the training the training data is supplied to the to-be-trained machine learning system, so that the machine learning system outputs an information model. The determined information model in a next step is compared with the actual information model associated with the training data. The deviations of the determined information model from the actual information model is evaluated with a cost function. The actual information model thereby is the information model which should result from the input data.

In a further step, parameters characterizing the behavior of the model are adapted with the aim that further processing of training data by the machine learning system is expected to improve the evaluation by the cost function. Preferably, the training of the machine learning system based on the training data is stopped before the machine learning system starts to overfitting.

With the described method for training a machine learning system it is possible to encoding the domain expertise that would otherwise be needed if the transformation was done manually by the user. The trained machine learning system can rapidly and economically generate information models. Further, all aforementioned advantages are achieved.

A preferred embodiment specifies that the machine learning system during usage operation is further trained by feedback information of a user. The user thereby identifies mistakes or errors in the information model and give a feedback to the machine learning system, so that the parameters can be adapted by a retraining process. Preferably, the information model is provided to the user in a graphical form. The user thereby can easily identify the errors and give a feedback to the system. More preferably, the user directly corrects the errors in the graphical representation. The step of giving a feedback to the machine learning system thereby is simplified, so that also a non-skilled user can provide a feedback to the machine learning system.

In particular, the method described above may, for example, be computer-implemented and thus embodied in software. The invention therefore also relates to a computer program comprising machine-readable instructions which, when executed on one or more computers, cause the computer or computers to perform the described method.

Similarly, the invention also relates to a non-transitory storage medium and/or a download product comprising the computer program. A download product is a digital product that is transferable via a data network, i.e., downloadable by a user of the data network, and that can be offered for sale, for example, in an online store for immediate downloading.

The computer program can be run on one or more computers. Accordingly, the computer can be a stationary computer or several computers in a cloud.

The above aspects and examples will become apparent from and be elucidated with reference to the embodiments described hereinafter.

### BRIEF DESCRIPTION OF THE DRAWINGS

The subject matter of the Invention will be explained in more details in the following description illustrated in the drawings, in which:
- Figure 1: Method and system for generating a structured machine understandable information model according to an embodiment of the invention, and
- Figure 2: Method for training a machine learning system for generating a structured machine understandable information model according to an embodiment of the invention.

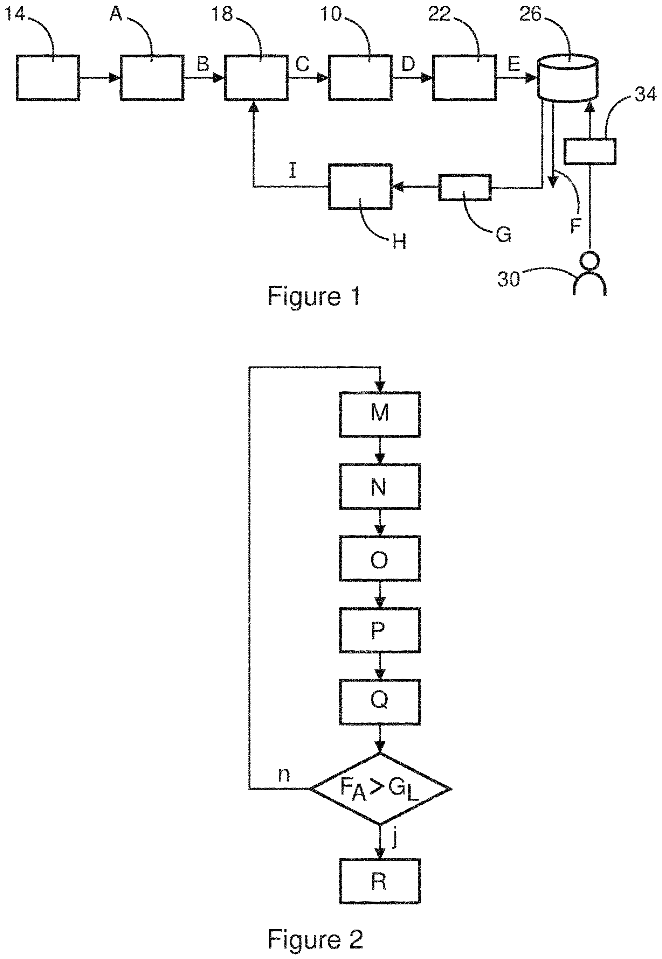

Figure 1 shows a method and system for generating a structured machine understandable information model 10 according to an embodiment of the invention. In a first step metadata 14, comprising an unstructured representation in natural language of names and/or locations of sensors, devices and/or actuators within the building together with telemetry data of the sensors, devices and/or actuators of the building, is preprocessed A, to remove data unnecessary for the generation of the information model 10. By doing so, the generation of the information model 10 can be accelerated.

The preprocessed data is then input B into a trained machine learning system 14. In the machine learning system 18 the information model 10 is generated via a natural language processing. In a further example, the information model 10 is generated by a graph-based model neural network. Further, in the machine learning system 18, the information model 10 can be generated via natural language understanding and natural language generation. Finally, in step C, the structured machine understandable information model 10 for the metadata and telemetry data of the building is output. The information model 10 thereby can be presented in a hierarchical structure.

This information model 10 is input D in a validator 22. The validator 22 checks if the information model 10 fits within specific constraints. Further, the validator 22 enhances the information model 10 by using prebuild templates for common room configuration and asset types of the building. The checked information model in a next step E is stored in a storage 26. The storage 26 can be a cloud or a storage medium. The information model 10 can be checked F by a user 30. Based on the information model 10 the user 30 has the option to give a feedback 34 to the information model 10. Based on the feedback information 34 a retraining step G is started. In this retraining, parameters characterizing the behavior of the model are adapted H. These parameters are input I to the machine learning system 18 to update the machine learning system 18.

Figure 2 shows a method for training a machine learning system 18 for generating a structured machine understandable information model 10. In a first step M, training data is provided, comprising metadata provided as an unstructured representation in natural language of names and/or locations of sensors, devices and/or actuators within the building, together with telemetry data of the sensors, devices and/or actuators of the building. Further, an information model 10 is provided which is associated with this data. This information model 10 thereby is a representation of an information model 10, which should come from the machine learning system 18 after processing of the data. This information model 10 can be taken from other buildings, to which an information model 10 has already been generated by a user.

In a next step N, the training data is supplied to the to-be-trained machine learning system 18, so that the machine learning system 18 outputs an information model 10. The machine learning system 18 thereby generates an information model 10 based on the data. This determined information model 10 is compared O to the actual information model 10 associated with the training data. In a next step P, the deviations between the determined information model 10 and the actual information model 10 are evaluated with a cost function.

Further, parameters characterizing the behavior of the model are adapted Q with the aim that further processing of training data by the machine learning system 18 is expected to improve the evaluation by the cost function. Finally, a factor F_{A} specifying the accuracy is compared with a limit value G_{L}. If the accuracy factor F_{A} is below the specified limit value G_{L}, the training is repeated until this condition is fulfilled. Then the generating of an information model 10 with the machine learning system 18 is released R. In a further option it is also possible to consider the training progress of the machine learning system 18 and to stop the training, before the machine learning system 18 starts overfitting.

### List of reference numbers

- 10: information model
- 14: metadata
- 18: machine learning system
- 22: validator
- 26: storage
- 30: user
- 34: feedback
- A: Preprocessing of the metadata
- B: Input of metadata in machine learning system
- C: Output of the information model
- D: Input of the information model in validator
- E: Stored in a storage
- F: Checked by a user
- G: Retraining step
- H: Adapting parameters
- I: Input parameters in machine learning system
- M: Provide training data
- N: training data supplied to the to-be-trained machine learning system
- O: Comparing determined information model with actual information model
- P: Determine deviations
- Q: Adapting parameters of the model
- R: Releasing machine learning system
- G_{L}: limit value
- F_{A}: accuracy factor

## Claims

1. Method for generating a structured machine understandable information model (10) for a building with automation control system, comprising the steps of:
- Input (B) of metadata, comprising an unstructured or semi-structured representation in natural language of names and/or locations of sensors, devices and/or actuators within the building together with telemetry data of the sensors, devices and/or actuators of the building, into a trained machine learning system (18), and
- Output (C) of the structured machine understandable information model (10) for the metadata and telemetry data of the building.

2. Method according to claim 1, **characterized in that** the generated information model (10) is validated by a validator (22), which checks if the information model (10) fits within specific constraints.

3. Method according to claim 2, **characterized in that** the validator (22) enhances the information model (10) by using prebuild templates for common room configuration and asset types of the building.

4. Method according to one of the preceding claims, **characterized in that** the information model (10) is a hierarchical structured model and/or graph structured based model.

5. Method according to one of the preceding claims, **characterized in that** the information model (10) is generated via a natural language processing.

6. Method according to claim 5, **characterized in that** the information model (10) is generated by a graph-based neural network model.

7. Method according to claim 5 or 6, **characterized in that** the information model (10) is generated via a natural language understanding and/or natural language generation.

8. Method according to one of the preceding claims, **characterized in that** the metadata and the telemetry data are preprocessed (A) before inputting the data in the machine learning system (18), to remove data unnecessary for the generation of the information model (10).

9. Method according to one of the preceding claims, **characterized in that** the information model (10) is output as a graphical information.

10. Method according to one of the preceding claims, **characterized in that** the information model (10) is adapted based on a feedback of a user.

11. Method for training a machine learning system (18) for generating a structured machine understandable information model (10) for a building with automation control system, comprising
- Providing training data (M), comprising metadata provided as an unstructured representation in natural language of names and/or locations of sensors, devices and/or actuators within the building, together with telemetry data of the sensors, devices and/or actuators of the building, and an information model (10) associated with this data;
- Supplying (N) the training data to the to-be-trained machine learning system (18), so that the machine learning system (18) outputs an information model (10);
- Comparing (O) the determined information model (10) with the actual information model (10) associated with the training data;
- Evaluating (P) the deviations of the determined information model (10) from the actual information model (10) with a cost function; and
- Adapting (Q) parameters characterizing the behavior of the model with the aim that further processing of training data by the machine learning system (18) is expected to improve the evaluation by the cost function.

12. Method according to claim 11, **characterized in that** the machine learning system (18) during usage operation is further trained by feedback information (34) of a user (30).

13. One or more computer programs, containing machine-readable instructions that, when executed on one or more computers, cause the one or more computers to perform a method of any one of claims 1 to 12.

14. A non-transitory storage medium and/or a download product with the computer program of claim 13.

15. One or more computers with the computer program of claim 13 and/or with the non-transitory storage medium and/or download product of claim 14.
